# EUROPEAN PATENT SPECIFICATION

(11) **EP 3 631 040 B1**
(45) Date of publication and mention of the grant of the patent: **25.10.2023**
(21) Application number: 18726803.2
(22) Date of filing: 23.05.2018
(51) Int. Cl.: C23C 14/06, C23C 28/04, C23C 28/00, C23C 14/50, C23C 14/32, F01D 5/28

(54) **THICK TIALTAN/ALCRN MULTILAYER COATING FILMS ON TURBINE COMPONENTS**
DICKE TIALTAN/ALCRN-MEHRSCHICHTLACKIERUNGEN AUF TURBINENBAUTEILEN
FILMS DE REVÊTEMENT MULTICOUCHES ÉPAIS DE TIALTAN/ALCRN SUR DES COMPOSANTS DE TURBINE

(30) Priority: 23.05.2017 US 201762509900 P; 20.12.2017 US 201762608066 P
(43) Date of publication of application: 08.04.2020
(73) Proprietor: Oerlikon Surface Solutions AG, Pfäffikon, 8808 Pfäffikon SZ (CH)
(72) Inventor: RUDIGIER, Helmut, 7000 Chur (CH); ARNDT, Mirjam, 7310 Bad Ragaz (CH); RACHBAUER, Richard, 9556 Liebenfels (AT); BOLVARDI, Hamid, 7000 Chur (CH); SHANG, Lin, 7310 Bad Ragaz (CH); MAYRHOFER, Paul Heinz, 7311 Neckenmarkt (AT); SEIDL, Wolfgang Markus, 1120 Wien (AT)
(74) Representative: Misselhorn, Hein-Martin
(86) International application number: PCT/EP2018/063546
(87) International publication number: WO 2018/215558

(56) References cited:
- EP-A1- 1 400 609
- WO-A1-98/44163
- WO-A1-2013/156131
- US-A1- 2008 193 782
- US-A1- 2015 259 782
- SEIDL W.M. ET AL: "Mechanical properties and oxidation resistance of Al-Cr-N/Ti-Al-Ta-N multilayer coatings", SURFACE AND COATINGS TECHNOLOGY, [Online] vol. 347, 1 August 2018 (2018-08-01), pages 427-433, XP93027996, NL ISSN: 0257-8972, DOI: 10.1016/j.surfcoat.2018.05.025 Retrieved from the Internet: URL:https://www.sciencedirect.com/science/ article/pii/S0257897218305000/pdfft?md5=50 1ec451edca0080ab13e3dc07a5b190&pid=1-s2.0- S0257897218305000-main.pdf> [retrieved on 2023-02-01]

## Description

The present invention relates to coated turbine parts (in the context of the present invention the term "turbine parts" refers to "any part of a turbine", in particular refers to "any turbine component"), which are coated with thick TiAITaN/AICrN multilayer films (hereafter also referred to as TiAITaN/CrAIN or AITiTaN/CrAIN or AITiTaN/AICrN multilayer films), thereby showing enhanced wear resistance performance, in particular regarding erosion resistance at elevated temperatures.

### Field and background of the invention

As mentioned in WO2014037104, Ti-AI-Ta-N monolayer and multilayer coatings are well known and described in different documents, e.g. in WO2009003206, WO20091 05024, EP2096811, EP1722009, EP1378304, EP1400609, EP1452621, EP1378304, JP7331410, JP7026386, JP6330347 and JP2007015071. In WO2014037104 different combinations of multilayer coatings were analyzed and compared with monolayer coatings. In particular, it is proposed in WO2014037104 to deposit multilayer coatings formed of A and B layers deposited alternate one on each other, wherein the A layers do not contain Ta and exhibit a higher defect density that the B layers, which contain Ta. Such coatings should provide in particular high wear resistance.

In WO2017080645 it is explained that in the case of coatings for turbine parts, in particular in cases where tipping is used, the known technology is limited in general to thicker hard coatings such as those deposited by thermal spray techniques, wherein coatings applied by these techniques are in general 100 to 200 micrometers thick and suffer some disadvantages. It is furthermore proposed in WO2017080645, to provide physically vapor deposited (PVD) thin films on blade tips in order to reinforce the tip of the blades against wear resulting from interaction of the blade tips with the abradable counterpart. The thin film should be provided on the blade surfaces that come into contact with abradable clearance control coatings. Moreover, in WO2017080645 it is mentioned that PVD coatings which are known from cutting tool applications may be advantageously used in this context and show excellent protection performance, in particular if coated on titanium alloy, stainless steel and/or nickel alloy blades which are used on low and high pressure compressor rotors and blisks in aero engines, and industrial gas turbine compressor rotors.

The inventors found however, that there is not any optimal PVD coating solution for providing satisfactory wear resistance on determined turbine parts, in particular, when the turbine part to be protected or whose performance must be improved, is subjected to erosion at elevated temperatures.

### Objective of the present invention

An objective of the present invention is to provide a PVD coating solution for improving performance of turbine parts. Preferably the PVD coating solution should improve wear resistance of turbine components during exposition at elevated temperatures of 700 °C and more. More in particular the PVD coating solution should improve erosion resistance of turbine components having surfaces which are to be subjected to erosion at elevated temperatures of 700 °C and more.

### Description of the present invention

The objective of the present invention is attained by providing a coating on surfaces of turbine parts, more specifically on surfaces of turbine components to be subjected to erosion at elevated temperatures, wherein the coating comprises a multilayer film made of AlTiTaN layers (also referred to as TiAITaN layers) and CrAIN layers (also referred to as AlCrN layers) deposited alternate one on each other in such a manner that, the multilayer film exhibit a film thickness corresponding to a value between and including 10 and 40 micrometers, wherein the multilayered film exhibits a single phased face-centered structure. In some special cases exhibiting a film thickness corresponding to a value between and including 15 and 25 micrometers.

A coated turbine component according to the invention is defined in the appended claims.

Beneficial properties of AlCrN layers are in particular following:
- AlₓCr₁₋ₓN features excellent mechanical properties in addition to an outstanding oxidation resistance, based to the formation of outermost stable Al-rich oxide scales.

Beneficial properties of TiAIN layers are in particular following:
- metastable supersaturated Ti_{1-y}Al_{y}N coatings are well-known for their unique thermo-mechanical properties on the basis of decomposition processes at temperatures higher than 700 °C (so-called age-hardening).

Beneficial properties of Ta-doped TiAIN layers are in particular following:
- the addition of Ta to Ti_{1-y}Al_{y}N even allows for an increase of mechanical properties as well as oxidation resistance - yet still being inferior to that of AlₓCr₁₋ₓN

The inventors found surprisingly superior properties in multilayered films formed by combining the properties of AlCrN layers and Ta-doped TiAIN layers according to the present invention.

In particular it was demonstrated very surprisingly that:
- multilayer films having a structure of AlₓCr₁₋ₓN and Ti_{1-y-z}Al_{y}Ta_{z}N layers can be very advantageous in:
   ▪ Attaining increased film thickness, allowing deposition of thick protective coatings with thicknesses of more than 10 micrometers and even more than 20 micrometers.
   ▪ Achieving superior coating mechanical properties and oxidation resistance at elevated temperatures of 700°C and higher.
   ▪ Providing erosion resistance at elevated temperatures of 700 °C and higher.
   ▪ Attaining higher hardness

For showing the advantages of the present invention, in the present invention some examples of deposition of different TiAITaN/AICrN multilayer films according to the present invention will be described in the following:
• Different multilayer coatings were deposited, which differ in:
∘ Target arrangement
∘ Target composition
∘ Coating thickness

• The multilayer architecture was realized by:
∘ alternating cathode arrangement
∘ two-fold substrate rotation

• Main range of deposition parameters that were used is shown in the following Table 1:

| Table 1: Preferred coating parameters range: **Deposition Temperature** | **Deposition Pressure** | **Deposition Time** | **Bias Voltage** |
|---|---|---|---|
| 400-550 °C | N₂ 1.0-8.5 Pa | 1 h - 6 h | |
| **Target Composition** | Ti_{0.45}Al_{0.45}Ta_{0.10} | Al_{0.7}Cr_{0.3} | -40 - -80 V |
| | Ti_{0.475}Al_{0.475}Ta_{0.05} | | |
| **Arc Current (for arc evaporation of the targets)** | 150-200 A | 120-200 A | |

The film structural analyses were conducted by X-ray diffraction (XRD) using a PANalytical X'Pert Pro MPD diffractometer equipped with a CuKα radiation source. The diffraction patterns were collected in Bragg-Brentano geometry. Micrographs of the film fracture cross-sections were obtained with a FEGSEM Quanta F 200 Scanning Electron Microscope (SEM). The film chemistry was determined by using the SEM attached Energy-Dispersive X-ray Spectroscopy (EDS) detector at an acceleration voltage of 20 keV.

The hardness and indentation modulus of the as-deposited and vacuum-annealed samples were determined using an Ultra-Micro-indentation System equipped with a Berkovich diamond tip. The testing procedure included normal loads between 2 and 30 mN with steps of 1 mN. The hardness values were evaluated according to the Oliver and Pharr method. Thereby, we assured an indentation depth of less than 10 % of the coating thickness to minimize substrate interference.

The in-plane residual film stresses were determined using the sin² *ψ* method (sin² *ψ* range 0-0.8 (-)). The measured strains were converted into stresses using the X-ray elastic constants 1/2 s2 of TiN. The latter were calculated from *ab initio* single-crystal elastic constants assuming the Hill model.

The oxidation resistance was studied by annealing coated Al₂O₃ platelets under ambient air at 900 °C for periods of time between 0.5 and 20 h in a Nabertherm N11/HR furnace. The oxidized coatings were coated with a ZrN toplayer to protect these oxide scales during the subsequent grinding and polishing process for which the oxidized samples were embedded in a highly conductive embedding material. These polished cross sections were used to perform cross section EDS elemental line scans.

The chemical analyses of all analyzed coatings reveal slightly overstoichiometric nitrides, but for easier reference, we normalized their nitrogen/metal ratio to 1. Their metal fractions, with respect to the targets used, are given in Table 2.

**Table 2: Chemical composition of Ti-Al-Ta-N, Al-Cr-N and Ti-AI-Ta-N/AI-Cr-N multilayer coatings as obtained by EDS**

| Coating | Target composition | Overall coating metal composition |
|---|---|---|
| Al-Cr-N | Al_{0.70}Cr_{0.30} | Al_{0.62}Cr_{0.38} |
| Ti-Al-Ta-N | Ti_{0.45}Al_{0.45}Ta_{0.10} | Ti_{0.44}Al_{0.41}Ta_{0.15} |
| Ti-Al-Ta-N | Ti_{0.475}Al_{0.475}Ta_{0.05} | Ti_{0.49}Al_{0.44}Ta_{0.07} |
| ATAT | Al_{0.70}Cr_{0.30}/Ti_{0.475}Al_{0.475} Ta_{0.05} | Ti_{0.30}Al_{0.44}Cr_{0.22}Ta_{0.04} |
| AATT | Al_{0.70}Cr_{0.30}/Ti_{0.475}Al_{0.475} Ta_{0.05} | Ti_{0.27}Al_{0.46}Cr_{0.23}Ta_{0.04} |

The description of the deposition of the inventive coatings as well as the attained coating properties will be explained in more detail by using some examples and with help of following Figures:

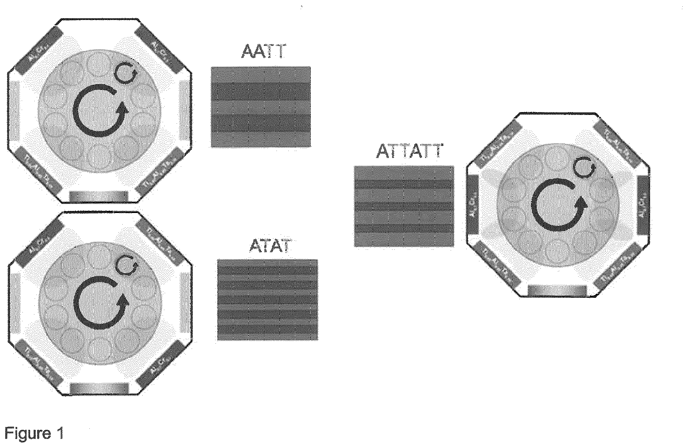

Figure 1: Configuration of the coating chamber and different arrangements of targets and substrates to be coated which were used for deposition of different multilayer films with different film architectures (and different bilayer periods), resulted from deposition with these different arrangements.
Figure 2: XRD patterns of the as-deposited multilayered films.
Figure 3: XRD patterns of as-deposited monolayer coatings of Ti_{0.49}Al_{0.44}Ta_{0.07}N and Al_{0.62}Cr_{0.38}N, respectively, as well as XRD patterns of as-deposited multilayered coating films comprising Ti_{0.49}Al_{0.44}Ta_{0.07}N and Al_{0.62}Cr_{0.38}N individual layers and having bilayer periods of λ=15, 24 and 31 nm, respectively. All coatings were deposited on austenite substrates.
Figure 4: SEM fracture cross-section images of monolithic coatings (a) Al_{0.62}Cr_{0.38}N, (b) Ti_{0.49}Al_{0.44}Ta_{0.07}N, and Ti_{0.49}Al_{0.44}Ta_{0.07}N/Al_{0.62}Cr_{0.38}N multilayer coatings with (c) AATT, (d) ATTATT, (e) ATAT arrangement, and the (f) 24.5 µm thick Ti_{0.49}Al_{0.44}Ta_{0.07}N/Al_{0.62}Cr_{0.38}N multilayer coating with ATTATT arrangement.

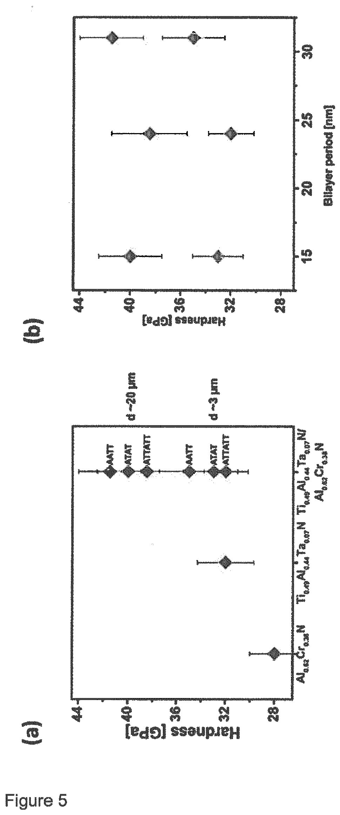

Fig. 5: a) Hardness of monolithic Al_{0.62}Cr_{0.38}N, Ti_{0.49}Al_{0.44}Ta_{0.07}N, and various Ti_{0.49}Al_{0.44}Ta_{0.07}N/Al_{0.62}Cr_{0.38}N multilayer coatings with respective coating thicknesses. The bilayer periods for ATAT, ATTATT, and AATT were calculated to be 15, 24, and 31 nm, respectively. The multilayer films outperform their monolithic counterparts. Significantly higher hardness values can be achieved by increasing the total film thickness from 3 to 20 µm. b) Hardness over the bilayer period for the multilayer coatings. The lower three hardness values correspond to ~3-pm-thin coatings, while the upper three hardness values are from over 15-µm-thick coatings. Lower hardness values of ~3-pm-thin coatings can be originated from substrate influence on hardness measurements.
Figure 6: a) Oxide scale thickness evolution during 900 °C oxidation of ~3-µm-thin Ti_{0.49}Al_{0.44}Ta_{0.07}N and Al_{0.62}Cr_{0.38}N coatings, and the Al_{0.62}Cr_{0.38}N/Ti_{0.49}Al_{0.44}Ta_{0.07}N multilayer (ATTATT architecture with λ = 24 nm). The diamond symbols show the thickness of the oxide scale of the corresponding coatings with higher Ta-content, Ti_{0.44}Al_{0.41}Ta_{0.15}N and Al_{0.62}Cr_{0.38}N/Ti_{0.44}Al_{0.4}Ta_{0.15}N, respectively.
Figure 7: EDS cross section scans of coatings after 20 hours at 900 °C in ambient air: (a) monolithic Ti_{0.49}Al_{0.44}Ta_{0.07}N, (b) monolithic Al_{0.62}Cr_{0.38}N, and (c) Ti_{0.49}Al_{0.44}Ta_{0.07}N/Al_{0.62}Cr_{0.38}N multilayer in ATTATT arrangement with λ = 24 nm.
Figure 8: Phase evolution of the Al_{0.62}Cr_{0.38}N/Ti_{0.49}Al_{0.44}Ta_{0.07}N multilayer with ATTATT arrangement and λ = 24 nm during annealing at 900 °C in ambient air. Pattern a is from the as deposited coating without substrate and patterns b, c, d, e, and f, are taken after 0.5, 1, 2, 5, and 20 h exposure at 900 °C of our Al_{0.62}Cr_{0.38}N/Ti_{0.49}Al_{0.44}Ta_{0.07}N multilayer on a polycrystalline Al₂O₃ substrate, respectively.
Figure 9: Wear rate determined by measuring the eroded wear depth after particle erosion tests with blast gun.
Figure 10: Picture of the equipment that was used for performing the particle erosion tests.
Figure 11: Fracture morphology of coatings with bilayer period of approximately 15 nm used for cavitation tests.
Figure 12: Comparison between results obtained by fatigue tests with uncoated Inconel 718 samples and Inconel 718 samples coated with a multilayered film according to the present invention.

As mentioned above Ti_{1-x-y}AlₓTa_{y}N and AlₓCr₁₋ₓN layers were deposited forming coating films with multilayer architectures. For the examples presented in the present description, these multilayered films were prepared by using a cathodic arc evaporation system of the type INNOVA produced by Oerlikon Balzers and TiAITaN and the AlCrN targets produced by means of powder-metallurgical techniques by Plansee Composite Materials GmbH.

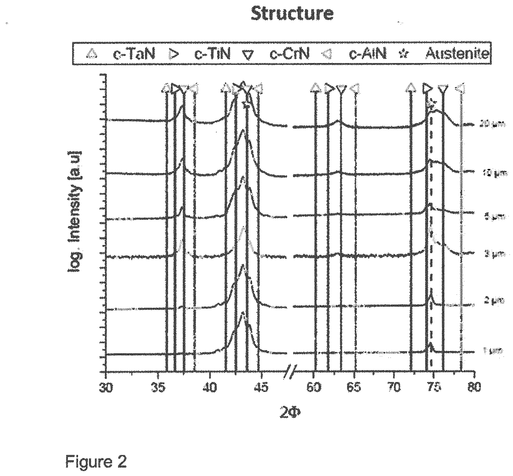

The XRD-patterns shown in Figure 2 suggest synthesis in single-phased supersatured metastable state, featuring a face-centered cubic structure with a crystallographic texture crossover from 200 to more polycrystalline structure for all multilayers coatings.

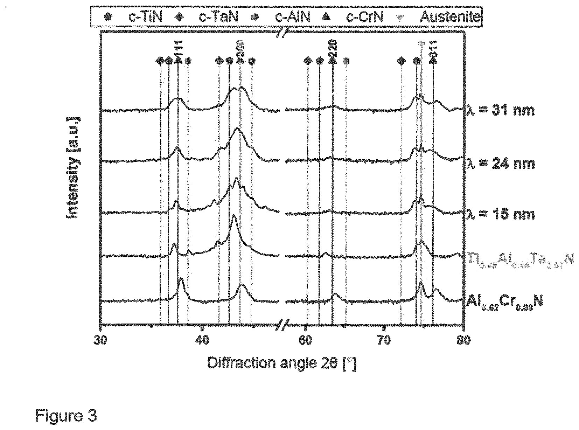

Likewise the XRD patterns shown in Figure 3 suggest a face-centered cubic crystal structure for all coatings. Especially, the fine-layered multilayers, ATAT and ATTATT with a bilayer period of about 15 and 24 nm, respectively, show cumulative diffraction peaks of the cubic structured Ti_{0.49}Al_{0.44}Ta_{0.07}N and Al_{0.62}Cr_{0.38}N phases, with corresponding satellite reflexes around the 200 XRD peak. Evaluating these leads to bilayer periods of 15.5 nm and 22.5 nm, in excellent agreement with those calculated from the deposition procedure. A tendency for double peak formation can be detected for the AATT multilayer having a larger bilayer period of about 31 nm. This can especially be seen at larger diffraction angles, with peaks around the TiN and CrN standard position (see Fig. 3 and 2θ - 75 deg.). All analyzed coatings, exhibit a rather random crystallographic growth orientation.

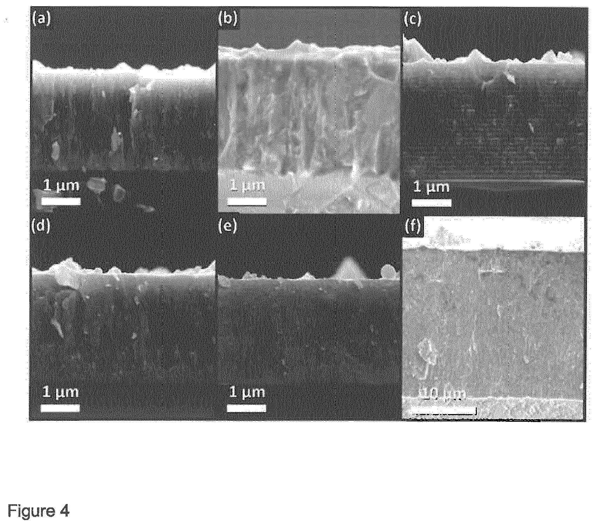

All analyzed films exhibit a dense growth morphology as it is shown in Figure 4. While the monolithic films (Figs. 4a and b) exhibit a more coarse-grained columnar structure, the combination of both constituents in a multilayer architecture results in a fine-grained and more equi-axed film morphology. Although the individual layers of these are too thin to be clearly resolved in the scanning electron micrographs, a periodic structure is visible, especially for the AATT multilayer coating (Fig. 4c). The periodic structure results from the different target arrangements and the two-fold rotation of the carousel during the deposition process. Depending on the relative position of the substrate to the sources, the substrates face periodic variations in plasma density, particle flux, and therefore slightly different growth rates and chemical compositions. This can also lead to periodic variations of the bilayer period. The calculated bilayer periods λ (obtained from the total coating thickness, the number of revolutions of the carousel during the coating process, and the number of bilayers formed in each revolution) of the different multilayer architectures are: 31 nm for AATT (Fig. 4c), 24 nm for ATTATT (Fig. 4d), and 15 nm for ATAT (Fig. 4e). The film morphology does not change significantly as a function of film thickness, see the 24.5 µm thick ATTATT multilayer coating, Fig. 4f.

The hardness of the multilayer coatings shows no clear trend with the bilayer period (see Fig. 5b. When growing these multilayers rather thick (24.5, 23.3, and 16.6 µm for ATTATT, ATAT, and AATT) their hardness increases to 38±1.8 GPa, 40±1.8 GPa, and 41.5±1.8 GPa. While increasing compressive residual stresses normally would expected an increment of the measured hardness, the thick multilayers produced according to the present invention exhibit actually lower compressive stresses as their thinner counterparts. After the sin² *ψ* measurements, the ~3-pm-thin ATAT, AATT, and ATTATT multilayers have compressive stresses of: -4.80±0.12 GPa, -4.12±0.12 GPa, and - 4.57±0.12 GPa, while their significantly thicker counterparts exhibit only -3.88±0.04 GPa, -4.02±0.08 GPa, and -3.41±0.12 GPa, respectively.

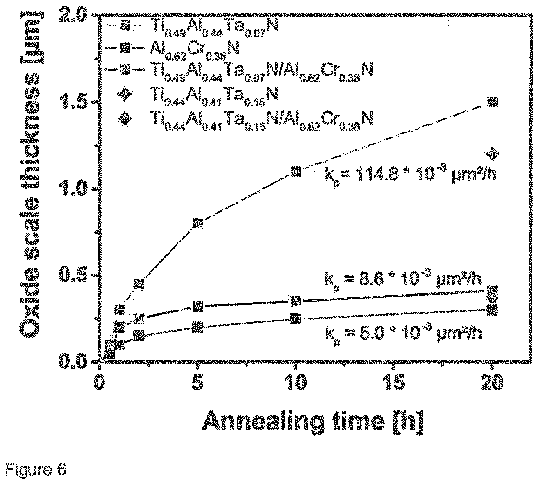

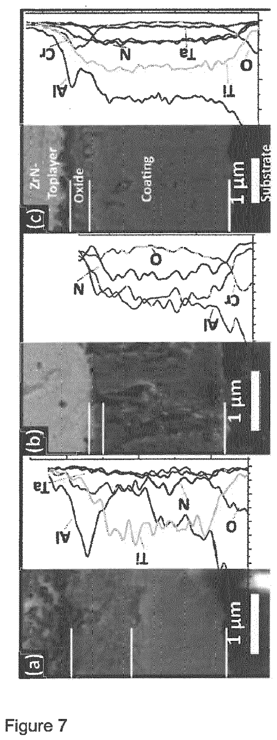

Exposing the Al_{0.62}Cr_{0.38}N and Ti_{0.49}Al_{0.44}Ta_{0.07}N coatings, as well as the Al_{0.62}Cr_{0.38}N/Ti_{0.49}Al_{0.44}Ta_{0.07}N multilayer with ATTATT architecture (λ = 24 nm) to ambient air at 900 °C for up to 20 h, highlights the need for Al and Cr to allow a significantly reduced oxide scale growth kinetic, see Fig. 6. While the oxide scale thickness dOx of Al_{0.62}Cr_{0.38}N immediately follows a parabolic growth rate with time t (dOx² = kp*t), a more paralinear growth rate is present for Ti_{0.49}Al_{0.44}Ta_{0.07}N. After an initial nearly linear growth rate, also Ti_{0.49}Al_{0.44}Ta_{0.07}N allows for a parabolic growth rate of the oxide scale thickness. Hence, the thickness evolution of the oxide scale is basically determined by the diffusion coefficient through the formed oxide scale. However, the parabolic rate constant kp for Ti_{0.49}Al_{0.44}Ta_{0.07}N with kp = 1.9 × 10-3 µm²/min (kp = 114.8 × 10-3 µm²/h) is significantly larger as kp for Al_{0.62}Cr_{0.38}N with 0.084 × 10-3 µm²/min (kp = 5.0 × 10-3 µm²/h), see Fig. 6. Thus, after 20 h, the Al_{0.62}Cr_{0.38}N coating shows a significantly thinner oxide scale (dOx ~0.3 µm) than the Ti_{0.49}Al_{0.44}Ta_{0.07}N coatings (dOx ~1.5 µm), see Figs. 7a and b, respectively. The Al_{0.62}Cr_{0.38}N/Ti_{0.49}Al_{0.44}Ta_{0.07}N multilayer (ATTATT, with λ = 24 nm) also starts with an initial linear-like oxide growth rate, but the subsequent parabolic regime with kp - 0.14 x 10-3 µm²/min (kp = 8.6 × 10-3 µm²/h) is comparable to Al_{0.62}Cr_{0.38}N. Consequently, also the multilayer coatings exhibit a nearly as good high temperature oxidation resistance as Al_{0.62}Cr_{0.38}N. After 20 hours, only an about 0.4 µm thick oxide scale formed (Fig. 7c). This corresponds to about 13 percent of the 3-µm-thick multilayers and under 2 percent of the thick multilayer coating with the same architecture but a total film thickness of 24.5 µm.

The rather thick oxide scale of -1.5 µm on Ti_{0.49}Al_{0.44}Ta_{0.07}N after oxidation for 20 hours at 900 °C in ambient air (Fig. 7a) shows an enrichment in Al and O in the outermost region. Underneath this outermost Al₂O₃-enriched region, the Al content is reduced but the Ti content is increased (see the EDS line scan next to Fig. 7a), suggesting for the typical alternating TiO₂-enriched and Al₂O₃-enriched regions for this type of coatings.

On the other hand, even after 20 hours at 900 °C only a small oxide scale of -0.25 µm is formed on Al_{0.62}Cr_{0.38}N, Fig. 7. This very dense scale acts as a barrier against further oxidation of the subjacent material. The remaining coating underneath the oxide scale, exhibits almost no detectable oxygen content (see the EDS line scan next to Fig. 7b).

Also the only ~ 0.35 µm thin oxide scale on top of the Ti_{0.49}Al_{0.44}Ta_{0.07}N/Al_{0.62}Cr_{0.38}N multilayer (with ATTATT arrangement and λ = 24 nm) - after 20 hours at 900 °C in ambient air - exhibits a dense growth morphology, Fig. 7c, with an Al-rich outermost region (see the EDS line scan next to Fig. 7c). Corresponding to Al_{0.62}Cr_{0.38}N, also this Ti_{0.49}Al_{0.44}Ta_{0.07}N/Al_{0.62}Cr_{0.38}N multilayer exhibits no detectable oxygen underneath the oxide scale.

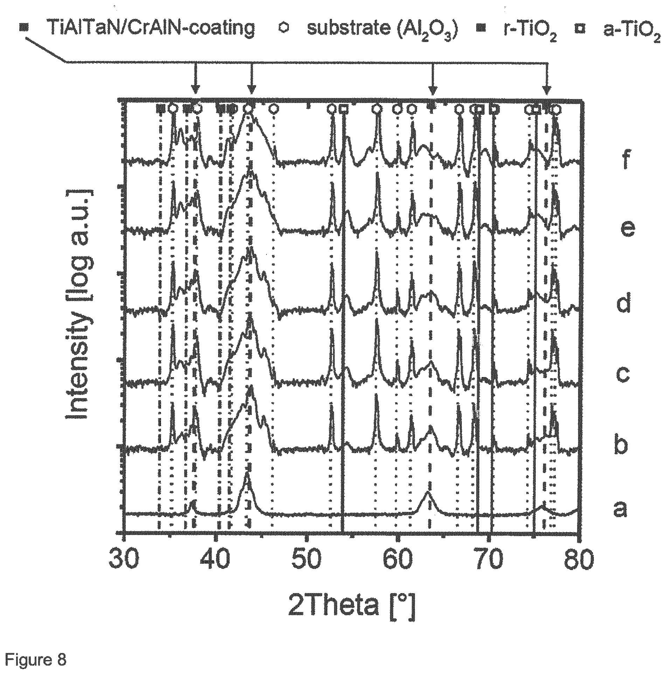

The XRD investigations of the Al_{0.62}Cr_{0.38}N/Ti_{0.49}Al_{0.44}Ta_{0.07}N multilayer with λ = 24 nm after exposure to ambient air at 900 °C for various times (Fig. 8) clearly shows their structural changes and formation of oxides. After 30 min nearly no oxide phases can be detected (pattern b in Fig. 8), the significant reflexes at Al₂O₃ XRD peak positions stem from the polycrystalline Al₂O₃ substrate. However, the major nitride XRD peak at ~43 deg is clearly decorated (on both sides) with well-developed satellite reflexes due to the multilayer structure. In the as deposited state (pattern a in Fig. 8) this is not that clearly developed, because the built-in structural defects (like point and line defects) interfere with the superstructure of the multilayer. Annealing at 900 °C leads to significantly reduced defect densities and hence the multilayer structure is better represented during these XRD investigations. Even after annealing for 1, 2, and 5 h (pattern c, d, and e in Fig. 8) the satellite reflexes are clearly present and nearly unchanged to the 0.5 h condition. This suggests for a well-protected multilayer structure by the formed topmost oxide scale (see Fig. 7 c). Only after 20 h (pattern f in Fig. 8) the satellite peaks are not that well developed anymore. The formation of anatase and rutile TiO2, which can already be detected after 0.5 h, gradually proceeds with time. The presence of anatase indicates that the Ta content of 7 % (at the metal sublattice of the Ti_{0.49}Al_{0.44}Ta_{0.07}N layers) is too low to directly promote the formation of rutile TiO₂ and suppress anatase TiO₂.

It can be concluded that all multilayer films according to the present invention exhibit a single phase-centered cubic structure in the as-deposited state and due to the formation of an Al-rich oxide scale, the high temperature oxidation resistance of the multilayer film is nearly as good as that of Al_{0.62}Cr_{0.38}N, withstanding oxidation at 900 °C easily for more than 20 hours with a parabolic growth rate constant of kp - 0.01 µm2/h. Increasing the total film thickness to 20 µm boosts the hardness up to 41.5 ±1.8 GPa and at the same time provides additional protection of the coated parts against oxidation.

The effects of chemical composition and architecture were analyzed taking into consideration the residual stress design. It was determined that:
- Interfaces represent locations where stress relaxation can take place. By controlling the interface area also the residual stresses can be controlled.
- By decreasing the bilayer period (Λ = TiAlTaN + AlCrN), the interface volume consequently increases
- It was possible to vary the bilayer period by:
   o modifying target arrangement
   o modifying carousel rotation speed
   o modifying duration of the individual layer deposition period
   o modifying arc current used for arc evaporation of the targets
- It was found beneficial to combine TiAITaN + AlCrN with compositions, which allow for an optimization of lattice parameter match between the sublayer for stress control

Application relevant tests were carried out (same kind of coatings and coated substrates were used for conducting the tests):

### Solid particle erosion tests:

Solid particle erosion tests (also called simply erosion tests in the context of the present invention) were carried out under 90° impingement angle with corundum Al₂O₃ particle, F240 (d50: ~50 µm) as abrasive material. Test duration was 300 seconds and the air pressure 3.5 bar.

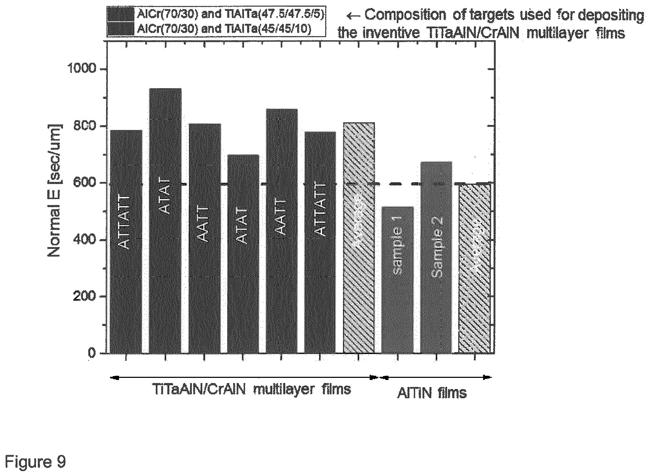

The erosion tests were performed by involving the impact of the coated surface to be tested with particles of controlled size and composition, impinging at an angle of 90°. The wear rate is determined by measuring the eroded wear depth. After analysis of the results of the particle erosion tests it was determined that:
- Results (at 90°) of AlCrN-TiAlTaN multilayer films compared to AlTiN, show a promising applicability potential as can be observed in Figure 9.

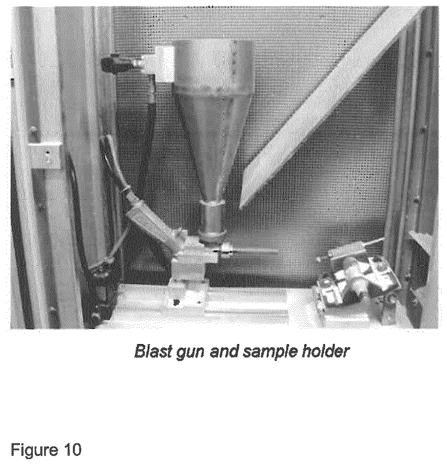

Figure 10 shows a picture of the equipment that was used for performing the above mentioned particle erosion tests.

### Cavitation tests:

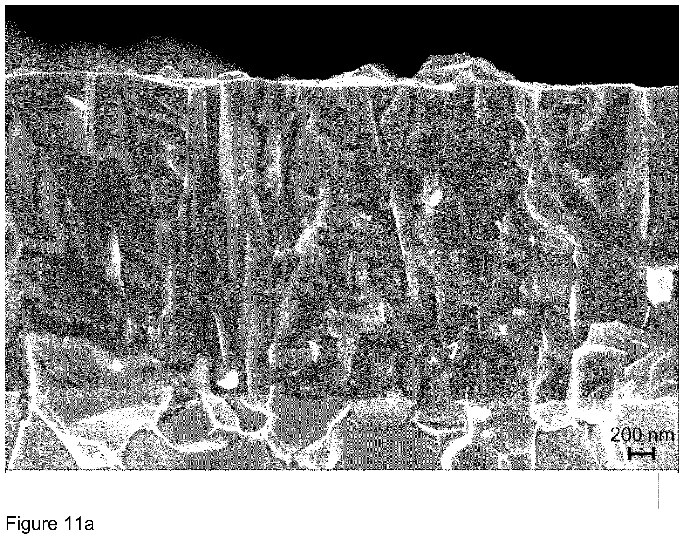

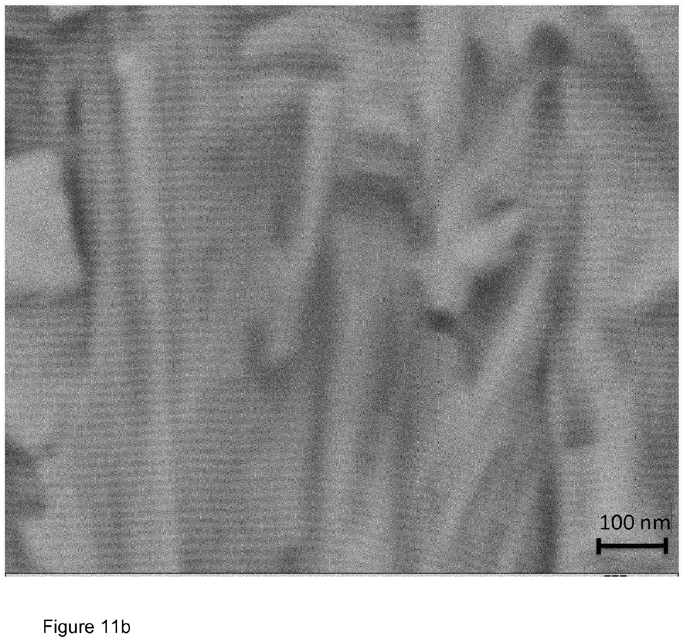

In order to test the developed AlₓCr₁₋ₓN/Ti_{1-x-y}AlₓTa_{y}N coatings in other turbine application relevant tests than solid particle erosion, coatings comprising Ti_{1-x-y}AlₓTa_{y}N and AlₓCr₁₋ₓN multilayered films were deposited on polished steel 1.4313 plates and Inconel 718 specific substrates. The aforementioned depositions were done in an Oerlikon Balzers INNOVA industrial-scaled cathodic arc evaporation system using two powder-metallurgical Ti_{0.475}Al_{0.475}Ta_{0.10} targets and two powder-metallurgical Al_{0.7}Cr_{0.3} targets. Based on the previous particle erosion test results, the most promising performing architecture AATT was selected in order to ensure best erosion resistance properties from analyzed inventive coatings. The measured hardness values of the deposited coatings were 36 ± 2 GPa which were significantly higher than 32 ± 1.8 GPa and 28 ± 1.7 GPa for monolithically grown Ti_{0.44}Al_{0.51}N and Al_{0.62}Cr_{0.36}N, respectively. Coatings possess a single phase face-centered cubic structure and a multilayer columnar structures with the bilayer period of approximately 15 nm as shown in Figure 11.

The steel coated plates were tested in cavitation tests where the resistance of the coating against water erosion was measured. Cavitation test resembles the water droplet erosion occurring on coated / uncoated turbine blades in real application conditions. 1.4313 steel was selected as application relevant substrate to be coated for the aforementioned test. The coated samples were produced having a coating thickness of higher than 10 µm. The results presented in table 3 correspond were obtained in tests which were running for 20 hours on two similar coated 1.4313 steels samples as well as two similar uncoated 1.4313 steels. Subsequently, after 20 h of measurement, samples were investigated. The caused erosion on the coated and uncoated steel plates were quantified in terms of average mass loss (mg), average wear depth (µm) and maximum wear depth (µm). The results of coated steel substrates were directly compared with the ones of uncoated. The lower average mass loss and wear depth were considered as higher resistance factors to water erosion. The results of these tests are summarized in Table 3. Coated samples demonstrate 3.8 mg average mass loss which is one order of magnitude lower compared to 40.6 mg mass loss of the uncoated ones. Same superior performance can also be observed when comparing average wear depths of the coated samples with 3.7 µm and 52.2 µm for coated and uncoated samples, respectively. A substantial erosion resistance increase has been obtained by use of the developed AlₓCr₁₋ₓN/Ti_{1-x-y}AlₓTa_{y}N coatings compared to uncoated case.

**Table 3: Comparison of results obtained by cavitation tests of uncoated samples and samples coated with multilayered films according to the present invention**

| | **Uncoated samples** | | | **Coated samples** | | |
|---|---|---|---|---|---|---|
| | Sample 1 (20h) | Sample 2 (20h) | Average | Sample 1 (20h) | Sample 2 (20h) | Average |
| mass loss | 41.4 mg (100%) | 39.8 mg (100%) | 40.6 mg (100%) | 4.1 mg | 3.5 mg | 3.8 mg |
| average wear depth | 52 µm (100%) | 53 µm (100%) | 52.5 µm (100%) | 4.6 µm | 2.7 µm | 3.7 µm |

In all tests it was observed a surprisingly higher resistance to cavitation showed by a reduction of mass loss and also a reduction of average wear depth of 90 % or more, when the surfaces coated according to the present invention were tested. The mass loss and average wear depth were measured in in mg and µm for uncoated and coated surfaces, respectively. The mass loss and the average wear depth obtained by tests with the uncoated surfaces was considered as 100%, respectively. The percentage of reduction of mass loss and wear depth measured by testing the surfaces coated according to the present invention were calculated respectively. The measured values obtained by testing uncoated and coated samples are shown in Table 3.

### Fatigue tests:

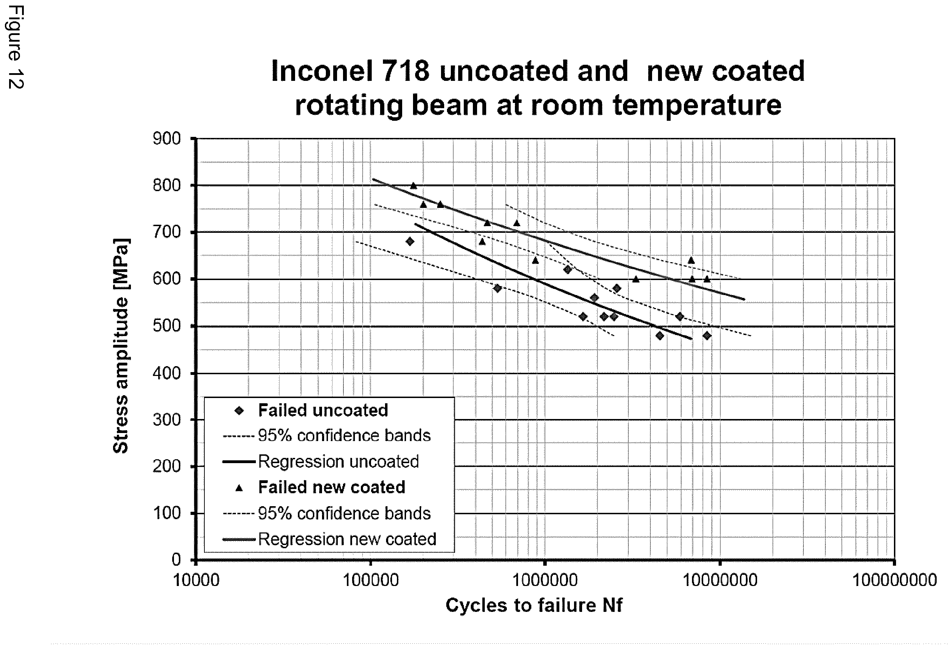

Inconel 718 coated substrates were used in fatigues tests in order to ensure that the applied coating do not impose fatigue debit on the substrate. Fatigue test substrates were coated and subsequently tested in a rotating setup at room temperature with 80-100 Hz frequency and a run out limit of 10 × 10⁶ cycles. Statistical evaluation was done according to Hück/IABG [M.Hück: Ein verbessertes Verfahren für die Auswertung von Treppenstufenversuchen; Z. Werkstofftech. 14, 406-4171 (1983)] and rounding were done in accordance with ASTM E29. As it can be seen clearly from Figure 12, no fatigue debit was observed for the coated samples.

### Further analysis:

### Analysis of mechanical properties of monolithic coatings in order to better understand the effect of the Ta content in the mechanical properties of Ta-doped TiAIN layer:

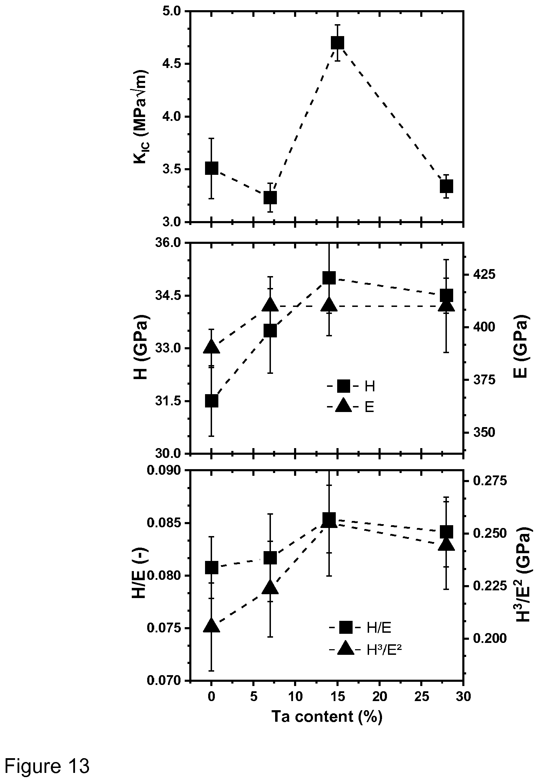

Figure 13 shows mechanical properties of coatings investigated regarding (a) fracture toughness K_{IC}, (b) hardness ans indentation modulus, and (c) H/E and H³/E² ratios, wehere H = hardness and E = indentation modulus or Youngs' modulus.

The fracture toughness K_{IC} of monolithic Ti_{0.54}Al_{0.46}N coatings was 3.5±0.3 *MPa*√*m.* The fracture toughness of the low Ta-containing coating, Ti_{0.49}Al_{0.44}Ta_{0.07}N, was with 3.2±0.1 *MPa*√*m* rather similar to the Ta-free Ti_{0.54}Al_{0.46}N. The 15 at% containing coating, Ti_{0.44}Al_{0.41}Ta_{0.15}N, exhibits a significant increase in K_{IC} to 4.7±0.2 *MPa m*. However, a further increase in Ta content to 28 at%, Ti_{0.38}Al_{0.34}Ta_{0.28}N, leads to a decrease in K_{IC} to 3.3±0.1 *MPa*√*m.* See Figure 13, at the top plotted graphic showing K_{IC} depending on Ta content.

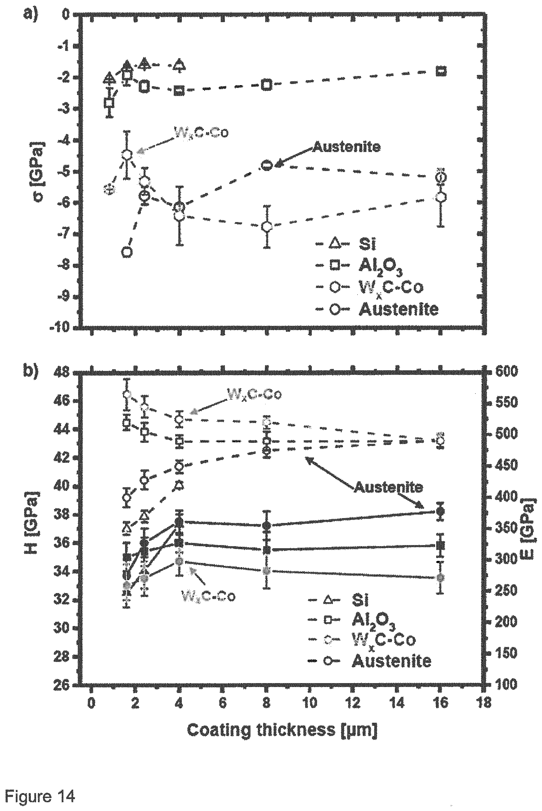

While Ti_{0.54}Al_{0.46}N shows hardness values of 31.5± GPa, the hardness Increases with Ta content to 33.5±1.5 GPa for Ti_{0.49}Al_{0.44}Ta_{0.07}N and to 35±1 GPa for Ti_{0.44}Al_{0.41}Ta_{0.15}N. The even higher Ta-containing coating exhibits a slightly lower hardness with 34.5±0.7 GPa for Ti_{0.38}Al_{0.34}Ta_{0.28}N. Furthermore, the indentation modulus (which is 390±7 GPa for Ti_{0.54}Al_{0.46}N) is rather similar with 410±15 GPa for all Ta-containing coatings investigated. See Figure 13, in the middle plotted graphic showing H (with squares) and E (with triangles) depending on Ta content. Therefore, the elastic strain to failure (H/E) and the plastic strain to failure (H3/E2) exhibit a maximum for the coating Ti_{0.44}Al_{0.41}Ta_{0.15}N, which also showed a maximum in hardness. See Figure 14, at the bottom plotted graphic showing H/E (with squares) and H³/E² (with triangles) depending on Ta content.

### Influence of coating thickness and substrate on stresses and mechanical properties of (Ti,AI,Ta)N/(AI,Cr)N multilayers:

Figure 14 shows an overview of (a) residual stresses (σ) and (b) indentation hardness (H) and indentation modulus (E) with the coating thickness of our AICrN/TiAITaN multilayers grown on Si, Al₂O₃, WₓC-Co, and austenite substrates (represented by triangular, square, hexagonal, and round data points). The values for H and E are represented by solid and open data points, respectively.

By comparing the growth stresses-vs.-thickness behavior of the deposited coatings on the different substrates used, see Fig. 14a, an excellent agreement of the coatings on Si and Al₂O₃ substrates as well as on WₓC-Co and austenite substrates can be observed. These data already consider the different coefficients of thermal expansion of the substrates, and represent the growth induced stresses (at deposition temperature). Interestingly, the coatings on the WxC-Co and austenite substrates exhibit significantly higher compressive stresses (by ~4 GPa, especially for coating thickness ≥ 4 µm). Our results suggest, that the higher compressive stresses within the coatings on WₓC-Co and austenite are mainly due to the significantly thicker substrate and thus, due to their more rigid behavior. The growth morphology is not significantly different between the coatings grown on Si or Al₂O₃ or on WₓC-Co or austenite. Also, the preferred growth orientation, especially for coating thickness ≥ 4 µm, is rather similar for the coatings on the different substrates.

The measured indentation moduli (E) of our AlCrN/TiAlTaN multilayers grown on Si, Al₂O₃, WₓC-Co, and austenite, clearly show the significant influence of the substrate used, Fig. 14b. The measured E moduli of the coatings grown on flexible substrates (Si and austenite, both have significantly lower Young's moduli than our coating) significantly increase with coating thickness. Contrary, those E moduli for coatings grown on stiffer substrates (Al₂O₃ and WₓC-Co, both have higher Young's moduli than our coating) significantly decrease with increasing coating thickness. All values meet at ~490 GPa for coatings with 16 µm (except the coatings on Si substrate, which could only be deposited up to 4 µm thick).

The hardness measurements are influenced by coating thickness, but also the Young's modulus of the substrates used. Substrates with higher Young's moduli, which thereby provide a lower elastic response to the loading during the nanoindentation experiments, lead to lower measured hardness values of the coating, and vice versa.

### Improved mechanical properties, thermal stabilities, and oxidation resistance, of arc evaporated Ti-AI-N coatings through alloying with Ta:

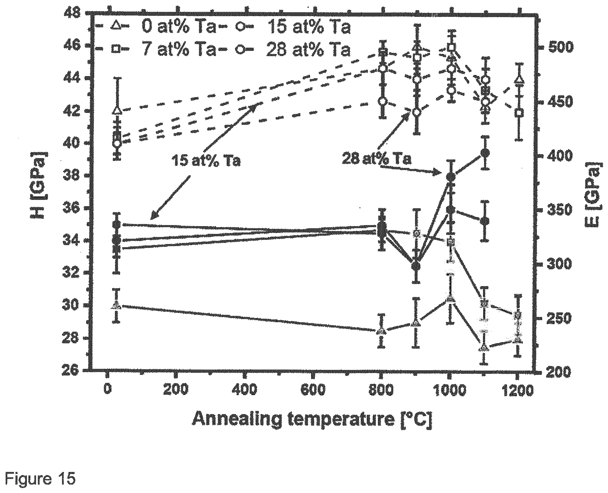

Figure 15 shows measured values of hardness (H, filled symbols) and indentation moduli (E, open symbols) for Ti_{0.54}Al_{0.46}N, Ti_{0.49}Al_{0.44}Ta_{0.07}N, Ti_{0.44}Al_{0.41}Ta_{0.15}N, and Ti_{0.38}Al_{0.34}Ta_{0.28}N, respectively, for non annealed and vacuum annealed coated samples up to 1200 °C. A clear age-hardening effect is evident, as well as a shift to higher temperatures for the significant hardness decline with increasing Ta content.

The achievable hardness values are directly correlated to the Ta content in the as-deposited coatings, leading to maximum values of 30.0±1, 33.5±1.5, 35.0±0.7, and 34.0±1.0 GPa for Ti_{0.54}Al_{0.46}N, Ti_{0.49}Al_{0.44}Ta_{0.07}N, Ti_{0.44}Al_{0.41}Ta_{0.15}N, and Ti_{0.38}Al_{0.34}Ta_{0.28}N coatings, respectively.

The age hardening effects are responsible for the excellent thermo-mechanical properties of Ti-AI-Ta-N films, reaching peak hardness values of 39.5±1.0 GPa for the coating with 28 at% Ta. The shift of the onset of the hardness increase to higher temperatures is based on the retarded spinodal decomposition and retarded formation of w-AIN at higher temperatures.

Concretely the present invention relates to:
- A coated turbine component comprising a surface to be exposed to erosion at temperatures of 700 °C or more and a coating covering at least partially the surface, wherein, the coating comprises a multilayered film formed of individual layers of titanium aluminum tantalum nitride, TiAITaN, and individual layers of aluminum chromium nitride, AlCrN, deposited alternate one on each other forming a multilayered architecture of the type ...TiAITaN/AICrN/ TiAlTaN/AlCrN/ TiAITaN/AICrN/..., wherein the thickness of the multilayered film is in a range between and including 10 and 40 and wherein the multilayered film exhibits a single-phased face-centered structure.
- According to a preferred embodiment of the invention, the directily above mentioned component is produced having the thickness of the multilayered film in a range between and including 15 and 25 micrometers.
- Preferably the component produced according to the present invention shows a coated surface of the turbine component exhibiting a higher resistance against water erosion in comparison with an uncoated surface, wherein the higher resistance against water erosion corresponds to a reduction of mass loss and/or to a reduction of average wear depth of 90% or more.
- As it is for example the case of the inventive coatings applied on the coated samples which were investigated by cavitation test and whose results are shown in table 3.
- The component according to the present invention is produced having the multilayered film exhibiting a single face-centered structure.
- The component is a turbine blade.
- According to a preferred embodiment of the present invention, the component is a tip of a blade.
- According to one more preferred embodiment of the present invention, the tip is one of them that is to be placed in a compressor of a turbine.
- According to another preferred embodiment of the present invention, the tip is one of them that is to be placed in a high temperature section of a turbine.
- The present invention suggest furthermore as preferred embodiment to produce the component having the multilayered film deposited as outermost layer of the coating.

## Claims

1. A coated turbine component comprising a surface and a coating covering at least partially the surface, **characterized in that**, the coating comprises a multilayered film formed of individual layers of titanium aluminum tantalum nitride, TiAlTaN, and individual layers of aluminum chromium nitride, AlCrN, deposited alternate one on each other forming a multilayered architecture of the type ...TiAITaN/AICrN/ TiAITaN/AICrN/ TiAITaN/AICrN/..., wherein the thickness of the multilayered film is in a range between and including 10 and 40 micrometers, wherein the multilayered film exhibits a single-phased face-centered structure .

2. The component according to claim 1, wherein the component is a tip of a blade.

3. The component according to claim 2, wherein the tip is placed in a compressor of a turbine.

4. The component according to claim 2, wherein the tip is placed in a high temperature section of a turbine.

5. The component according to any one of claims 1 to 4, wherein the thickness of the multilayered film is in a range between and including 15 and 25 micrometers.

6. The component according to any one of claims 1 to 5, wherein the multilayered film is deposited as outermost layer of the coating.

## Patentansprüche

1. Eine beschichtete Komponente einer Turbine, die eine Oberfläche und eine Beschichtung umfasst, die zumindest teilweise die Oberfläche bedeckt, **dadurch gekennzeichnet, dass** die Beschichtung einen mehrschichtigen Film umfasst, der aus einzelnen Schichten von Titan Aluminium TantalNitrid, TiAITaN, und einzelnen Schichten von Aluminium Chrom Nitrid, AlCrN, gebildet ist, die abwechselnd übereinander abgelagert sind und eine mehrschichtige Architektur vom Typ ...TiAlTaN/AlCrN/ TiAlTaN/AlCrN/ TiAlTaN/AlCrN/... bilden, wobei die Dicke des mehrschichtigen Films in einem Bereich zwischen 10 und 40 Mikrometern liegt, wobei der mehrschichtige Film eine einphasige flächenzentrierte Struktur aufweist.

2. Die Komponente gemäß Anspruch 1, wobei die Komponente eine Spitze eines Schaufelblatts ist.

3. Die Komponente gemäß Anspruch 2, wobei die Spitze in einem Verdichter einer Turbine platziert ist.

4. Die Komponente gemäß Anspruch 2, wobei die Spitze in einem Hochtemperaturbereich einer Turbine platziert ist.

5. Die Komponente gemäß einem der Ansprüche 1 bis 4, wobei die Dicke des mehrschichtigen Films in einem Bereich zwischen und einschließlich 15 und 25 Mikrometern liegt.

6. Die Komponente gemäß einem der Ansprüche 1 bis 5, wobei der mehrschichtige Film als äußerste Schicht der Beschichtung abgelagert ist.

## Revendications

1. Un composant de turbine revêtu comprenant une surface et un revêtement couvrant au moins partiellement la surface, **caractérisé en ce que** le revêtement comprend un film multicouche formé par des couches individuelles de nitrure de titane aluminium tantale, TiAITaN, et des couches individuelles de nitrure d'aluminium chrome, AlCrN, déposées alternées les unes sur les autres formant une architecture multicouche du type ...TiAITaN/AICrN/ TiAITaN/AICrN/ TiAITaN/AICrN/...' l'épaisseur du film multicouche étant comprise entre 10 et 40 micromètres, le film multicouche présentant une structure à phase unique faces-centrées.

2. Le composant selon la revendication 1, dans lequel le composant est une pointe d'une aube de trubine.

3. Le composant selon la revendication 2, dans lequel la pointe est placée dans un compresseur d'une turbine.

4. Le composant selon la revendication 2, dans lequel la pointe est placée dans une section haute température d'une turbine.

5. Le composant selon l'une quelconque des revendications 1 à 4, dans lequel l'épaisseur du film multicouche est comprise entre 15 et 25 micromètres.

6. Le composant selon l'une quelconque des revendications 1 à 5, dans lequel le film multicouche est déposé en tant que couche extérieure du revêtement.
